# EUROPEAN PATENT SPECIFICATION

(11) **EP 2 074 874 B1**
(45) Date of publication and mention of the grant of the patent: **03.02.2010**
(21) Application number: 07735565.9
(22) Date of filing: 19.04.2007
(51) Int. Cl.: H05K 5/02, H04M 1/02, G06F 1/16

(54) **ELECTRONIC DEVICE WITH DUAL FUNCTION OUTER SURFACE**
ELEKTRONISCHES GERÄT MIT EINER ÄUSSEREN OBERFLÄCHE MIT ZWEI FUNKTIONEN
DISPOSITIF ÉLECTRONIQUE AVEC UNE SURFACE EXTERNE À DOUBLE FONCTION

(30) Priority: 19.10.2006 US 550915
(43) Date of publication of application: 01.07.2009
(73) Proprietor: Sony Ericsson Mobile Communications AB, 221 88 Lund (SE)
(72) Inventor: NILSSON, Krister, 237 37 Bjarred (SE); HUGOSSON, Maria, 227 63 Lund (SE); RYDEN, Andreas, 212 16 Malmo (SE); KARLELID, Torbjorn, 212 32 Malmo (SE); VANTU, Florin, 231 74 Malmo (SE); TAKAMOTO, Taro, Beijing (CN)
(74) Representative: Valea AB
(86) International application number: PCT/IB2007/051431
(87) International publication number: WO 2008/047254

(56) References cited:
- EP-B- 0 878 989

## Description

### BACKGROUND

### Technical Field of the Invention

Implementations described herein relate generally to electronic devices and, more particularly, to heat dissipating surfaces of electronic devices.

### Description of Related Art

Electronic devices, such as mobile phones, media players, navigational devices, laptop computers, and hand held computers are becoming increasingly useful as technology shrinks the size and increases the computational power of such devices. All electronic devices require power to operate, some of which is given off as heat.

Heat sinks may be used in electronic devices to help dissipate heat into the ambient atmosphere. In certain situations, the electronic devices, and in particular, the surface of the heat sink surface, can become uncomfortably hot for the user.

### SUMMARY

According to one aspect, a device has an outer surface and includes a thermally conductive layer and second layer areas. The thermally conductive layer has an uneven surface and at least one other surface that is thermally coupled to a heat source. The uneven surface includes first areas that are higher than other areas of the uneven surface and further includes the second layer areas located on the first areas of the thermally conductive surface.

In another aspect, the second layer areas of the device may be non-thermally conductive areas.

In another aspect, the second layer areas of the device may include a plastic material or an elastomer. The thermally conductive layer may include a metal.

In another aspect, the thermally conductive layer may act as a heat sink for the device.

In another aspect, the uneven surface of the thermally conductive layer includes a wave like contour.

In another aspect, the uneven surface of the thermally conductive includes a hill like contour or a box like contour.

In another aspect, the second layer areas are formed of a material that is relatively easy to grip.

In another aspect, the first areas of the uneven surface are separated from the low areas of the uneven surface by approximately 0.2 millimeters to on the order of a few millimeters.

In yet another aspect, an electronic device includes a heat source and an outer surface portion. The outer surface portion includes a thermally conductive layer having an uneven surface and at least one other surface that is thermally coupled to the heat source. The uneven surface includes a plurality of raised areas. Further, the outer surface portion includes a number of second layer areas located on the raised areas of the thermally conductive surface.

In another aspect, the electronic device is a mobile terminal or a portable computer.

In another aspect, the second layer areas of the electronic device include non-thermally conductive areas.

In another aspect, the plurality of second layer areas of the electronic device each include a plastic material or an elastomer.

In another aspect, the thermally conductive layer includes a metal.

In another aspect, the uneven surface includes a wave like contour. The uneven surface may alternatively include a hill like contour or a box like contour.

In another aspect, the plurality of second layer areas may be formed of a material that is relatively easy to grip.

In yet another aspect, a dual function surface is provided that comprises means for dispersing heat, the means for dispersing heat having a thermally conductive uneven surface. The dual function surface further comprises means for insulating portions of the uneven surface with a material that is relatively non-thermally conductive.

In another aspect, the means for insulating portions of the uneven surface has a high coefficient of friction and a pleasant tactile feel.

In another aspect, the uneven surface has a wave contour.

### BRIEF DESCRIPTION OF THE DRAWINGS

The accompanying drawings, which are incorporated in and constitute a part of this specification, illustrate an embodiment of the invention and, together with the description, explain the invention. In the drawings,
Fig. 1A is a front side view of an exemplary electronic device;
Fig. 1B is a back side view of the exemplary electronic device;
Fig. 2 is a diagram illustrating a cross-section of an exemplary implementation of the dual function surface shown in Fig. 1B;
Fig. 3 is a diagram conceptually illustrating the exemplary implementation of dual function surface when in use by an operator;
Fig. 4 is a diagram illustrating a cross-section of an alternate exemplary implementation of the dual function surface shown in Fig. 1B;
Fig. 5 is a diagram illustrating a cross-section of another alternate exemplary implementation of the dual function surface shown in Fig. 1B; and
Fig. 6 is a diagram illustrating another exemplary electronic device in which the dual function surface is implemented.

### DETAILED DESCRIPTION OF EMBODIMENTS

The following detailed description of the invention refers to the accompanying drawings. The same reference numbers in different drawings may identify the same or similar elements. Also, the following detailed description does not limit the invention.

As described herein, an outer portion of an electronic device is given an uneven profile, such as a wavy profile, to aid in the dissipation of heat. The high points in the uneven profile, such as the peaks of the wavy profile, may be stamped or coated with a non-thermal conductive coating. The non-thermal conductive coating may be relatively pleasant to user touch. In this manner, the uneven profile portion of the electronic device functions to both dissipate heat while allowing the user to comfortably touch or hold the device.

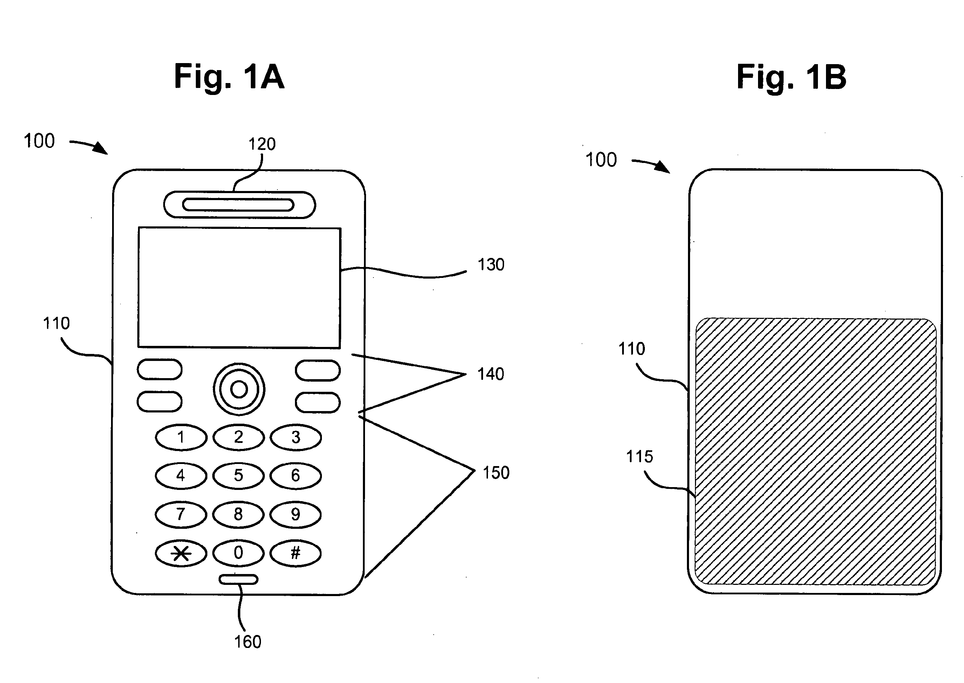

Figs. 1A and 1B are front side and back side views, respectively, of an exemplary electronic device 100. In this example, electronic device 100 is a mobile terminal. More generally, it can be appreciated that electronic device 100 can be any type of electronic device.

Device 100 may include housing 110, speaker 120, display 130, control keys 140, keypad 150, and microphone 160. Housing 110 may protect the components of device 100 from outside elements. Housing 110 may be made from thermoplastics, metals, elastomers (e.g., synthetic rubber and/or natural rubber), and/or other similar materials. Speaker 120 may provide audible information to a user of device 100. Display 130 may provide visual information to the user. For example, display 130 may provide information regarding incoming or outgoing telephone calls, games, telephone numbers, the current time, e-mail, etc. Control keys 140 may permit the user to interact with device 100 to cause device 100 to perform one or more operations. Keypad 150 may include a standard telephone keypad and may include additional keys to enable typing information into device 100. Microphone 160 may receive audible information from the user.

At least one portion of housing 110 of device 100 may include an uneven surface portion, referred to as a dual function surface 115 herein. In this example, dual function surface 115 is implemented on the back side of device 100. Dual function surface 115 is designed to dissipate heat while having a surface that is pleasant for the user to touch. Dual function surface 115 may generally be implemented on any external surface of housing 110, and can be particularly useful when implemented on areas of housing 110 from which it is desirable to dissipate heat, such as over a battery charging area or over an area an covers core circuitry of device 100.

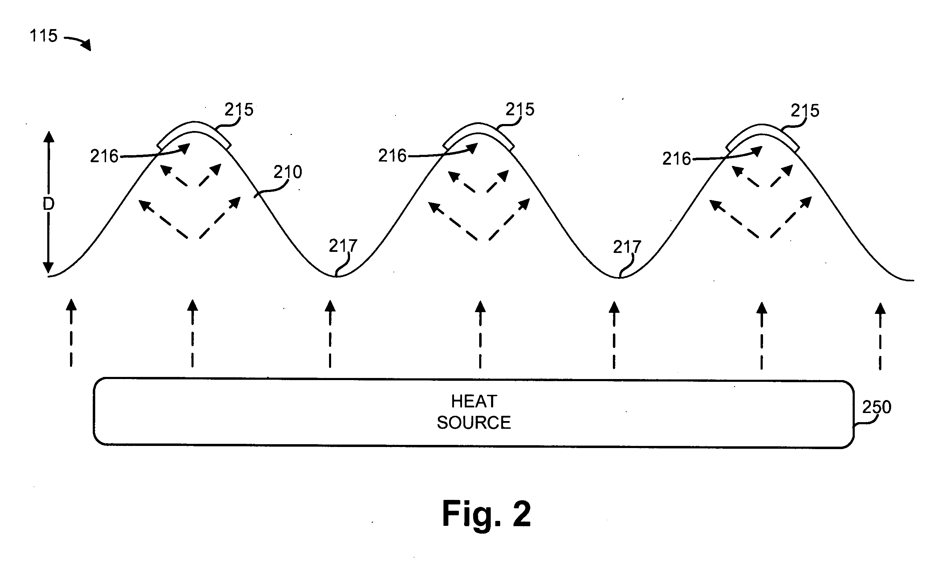

Fig. 2 is a diagram illustrating a cross-section of an exemplary implementation of dual function surface 115. In this implementation, dual function surface 115 is shown as having a "wavy" or wave-like profile that includes peak portions 216 that are higher than valley portions 217. The wavy profile may be formed by thermally conductive layer 210. Layer 210 may be made from, for example, a thermally conductive metal or other material. Layer 210 may generally operate to dissipate heat into the ambient atmosphere through the surface of layer 210. In other words, layer 210 may operate as a heat sink in which a top surface contacts the outside atmosphere and another surface is in contact with, or thermally coupled to, a heat source 250 that is to be dissipated. Heat source 250 may include internal heat producing elements of device 100, such as electronic circuitry. As conceptually shown via the dashed arrows in Fig. 2, heat generated by heat source 250 may move to the cooler outer surface of device 100 via layer 210. The uneven profile of the top surface of layer 210 provides a relatively large surface area for dissipating heat. The surface area of the top surface of layer 210 may be larger than if layer 210 was constructed as a flat surface, thus providing additional ventilation surface for heat exchange.

The top surface of layer 210 may be stamped or coated with non-thermal conductive areas 215. As shown, non-thermal conductive areas 215 may be located at or near the peaks of layer 210 (i.e., near peak portions 216). Non-thermal conductive areas 215 may, for example, be implemented as a plastic material (e.g., a thermoplastic) or as an elastomer (e.g., rubber). In general, the material may be selected as a material that is relatively non-thennally conductive and has a pleasing tactile feel and/or has a high coefficient of static or dynamic friction (i.e., it's "grippy"). The total area covered by the non-thermal conductive areas 215 may be less, and in some implementations, significantly less than the total area covered by dual function surface 115. Making layer 210 uneven serves to increase the available outer surface, for improved thermal exchange, and create a relief that allows for non-thermal conductive areas 215 to be simply added.

The amplitude of the waves of layer 210 may vary based on the design of the particular device, and may typically vary from the order of a few tenths of a millimeter to a few millimeters. For example, the amplitude, shown as distance "D" in Fig. 2, may range from approximately 0.2 - 0.5 millimeters to a few millimeters or greater (e.g., 3 millimeters or more).

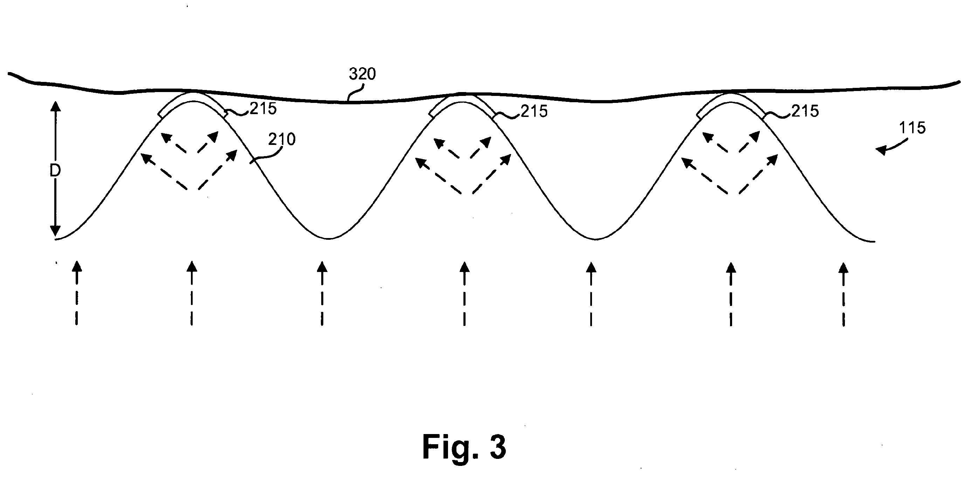

Fig. 3 is a diagram conceptually illustrating the exemplary implementation of dual function surface 115, as shown in Fig. 2, when in use by an operator. In this diagram, curve 320 represents an outline of a human hand touching (e.g., holding) electronic device 100 on dual function surface 115. The hand may tend to naturally contact non-thermal conductive areas 215, which may provide a pleasant tactile response/feel while providing shielding from the heat of layer 210. In some implementations, non-thennal conductive area 215 may be designed so that it is physically very difficult or unlikely for the operator's hand to contact layer 210. In other applications, it may be acceptable if some portion of the operator's hand comes into contact with layer 210. In other words, in some applications, non-thermal conductive area 215 may provide acceptable results without acting as a complete physical separator between the operator's hand and layer 210.

Dual function surface 115, as shown in Figs. 2 and 3 and as described, includes a thermally conductive layer 210 that includes uneven portions that are capped or topped by non-thermal conductive areas 215. The tops provided by non-thermal conductive areas 215 allow a user to hold electronic device 100 without actually contacting much or all of the heat dissipating portion of layer 210. Further, waves in dual function surface 115 provide for greater ventilation than a flat thermally conductive surface. Still further, since only the tops of the waves of layer 210 are covered with non-thermal conductive areas 215, manufacture of dual function surface 115 may be relatively simple and cheap to implement. For example, non-thermal conductive areas 215 may be stamped or pressed onto layer 210. In this manner, a surface is provided that is pleasant to touch, but yet provides effective heat dissipation. In some implementations, layer 210 may be a single continuous layer with the peak portions (i.e., portions 216) being made from a non-thermally conductive material and the remaining portions being made from a thermally conductive material.

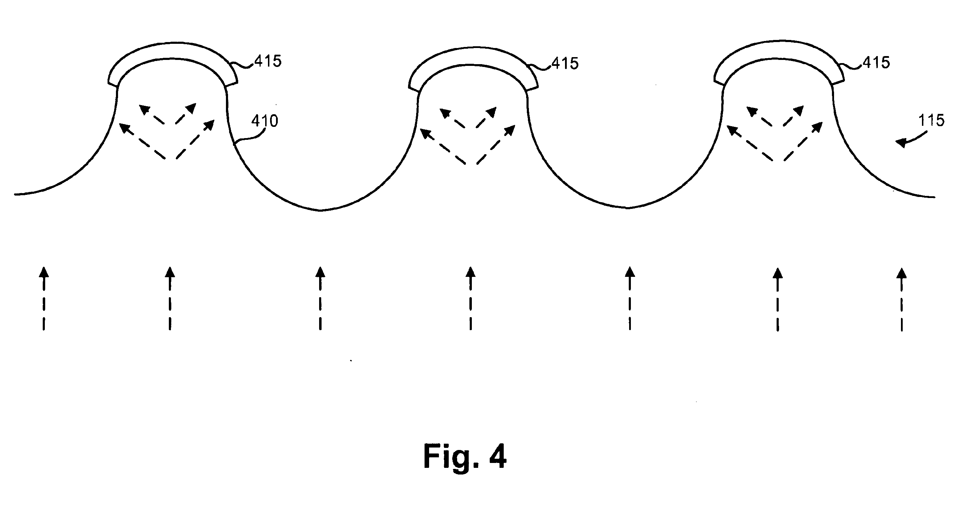

It can be appreciated that the "wavy" profile of the top surface of layer 210 is exemplary. Many other different profiles are possible and may be used to provide similar functionality. For example, Fig. 4 is a cross-section diagram illustrating an alternate exemplary implementation of dual function surface 115. In this implementation, dual function surface 115 includes a "hilly" profile. The hilly profile is formed by a thermally conductive layer 410. Thermally conductive layer 410 may be made of materials similar to and functions in a manner similar to layer 210 (described above).

Layer 410 may be stamped or coated with non-thermal conductive areas 415. Non-thennal conductive areas 415 function similarly to non-thermal conductive areas 215 (described above). That is, non-thermal conductive areas 415 may be located at or near the top of layer 410 and be selected as a material that is relatively non-thermally conductive and that has a pleasing tactile feel and/or is relatively easy to grip.

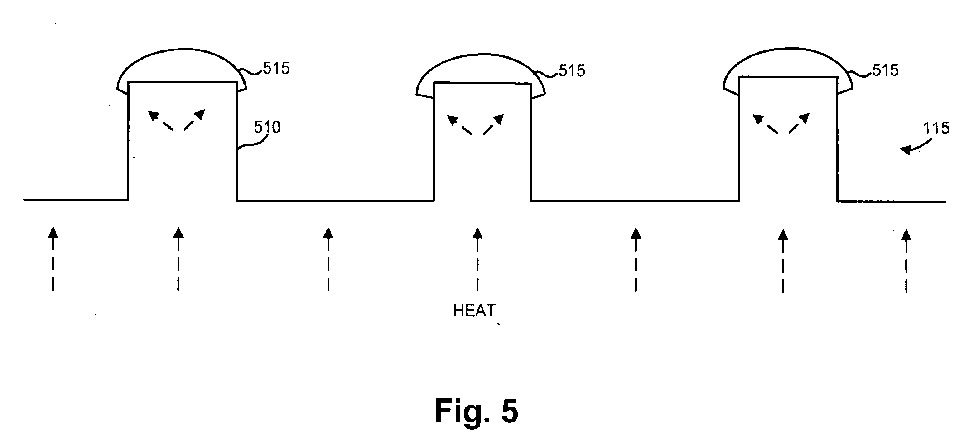

Fig. 5 is a cross-section diagram illustrating another alternate exemplary implementation of dual function surface 115. In this implementation, dual function surface 115 has a "boxy" profile. The boxy profile is formed by a thermally conductive layer 510. Thermally conductive layer 510 may be made of materials similar to and functions in a manner similar to layer 210 (described above).

Layer 510 may be stamped or coated with non-thermal conductive areas 515. Non-thermal conductive areas 515 function similarly to non-thermal conductive areas 215 (described above). That is, non-thermal conductive areas 515 may be located at or near the top of layer 510 and be selected as a material that is relatively non-thermally conductive and that has a pleasing tactile feel and/or is relatively easy to grip/hold.

Although dual function surface 115 is shown in Fig. 1B as being implemented in mobile terminal 100, it can be appreciated that dual function surface 115 could be implemented with any electronic device.

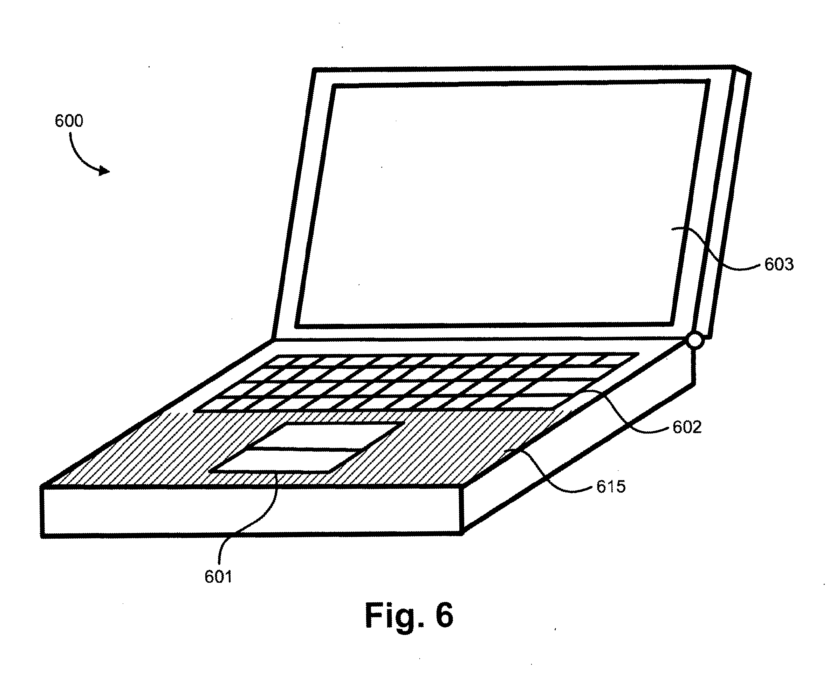

Fig. 6 is a diagram illustrating another exemplary electronic device in which the dual function surface is implemented. As shown, a portable computer (i.e., a laptop) 600 may include the dual function surface described above. Portable computer 600 may include, for example, a touch pad entry portion 601, a keyboard 602, and a display 603. Additionally, portable computer 600 includes a dual function surface 615 (shown as the area including diagonal lines). Dual function surface 615 may be implemented as described above, such as the implementations shown in Figs. 2-5. In this example, dual function surface 615 is located on a front portion of portable computer 600. It can be appreciated that in other implementations, dual function surface 615 may be located in other or in additional locations on portable computer 600, such as on a back or side surface of portable computer 600.

### CONCLUSION

As described above, a dual function surface acts as a heat sink to dissipate heat while also including relatively good tactile qualities.

The foregoing description of the embodiments of the invention provides illustration and description, but is not intended to be exhaustive or to limit the invention to the precise form disclosed. Modifications and variations are possible in light of the above teachings or may be acquired from practice of the invention.

It should be emphasized that the term "comprises/comprising" when used in this specification is taken to specify the presence of stated features, integers, steps, or components, but does not preclude the presence or addition of one or more other features, integers, steps, components, or groups thereof.

No element, act, or instruction used in the description of the present application should be construed as critical or essential to the invention unless explicitly described as such. Also, as used herein, the article "a" is intended to include one or more items. Where only one item is intended, the term "one" or similar language is used. Further, the phrase "based on," as used herein is intended to mean "based, at least in part, on" unless explicitly stated otherwise.

The scope of the invention is defined by the claims and their equivalents.

## Claims

1. An outer surface of an electronic device (100), comprising:
a thermally conductive layer (210, 410, 510) having an uneven surface and at least one other surface that is thermally coupled to a heat source (250), the uneven surface including a plurality of first areas (216) that are higher than other areas of the uneven surface; and
a plurality of second layer areas (215, 415, 515) located only on the first areas of the uneven surface, where the plurality of second layer areas (215, 514, 515) include a plastic material or an elastomer.

2. The outer surface of the electronic device (100) of claim 1,
wherein the plurality of second layer areas (215, 415, 515) are non-thermally conductive.

3. The outer surface of the electronic device (100) of claim 1,
wherein the thermally conductive layer (210, 410, 510) includes a metal.

4. The outer surface of the electronic device (100) of claim 1,
wherein the thermally conductive layer (210, 410, 510) acts as a heat sink for the device.

5. The outer surface of the electronic device (100) of claim 1,
wherein the uneven surface of the thermally conductive layer includes a wave like contour.

6. The outer surface of the electronic device (100) of claim 1,
wherein the uneven surface of the thermally conductive layer includes a hill like or box like contour.

7. The outer surface of the electronic device (100) of claim 1,
wherein the first areas (216) of the uneven surface are separated from lower areas of the uneven surface by a distance ranging from approximately 0.2 to on the order of a few millimeters.

8. An electronic device (100) comprising:
a heat source (250); and
an outer surface portion (115) that includes
a thermally conductive layer (210, 410, 510) having an uneven surface and at least one other surface that is thermally coupled to the heat source (250), the uneven surface including a plurality of raised areas (216); and
a plurality of second layer areas (215, 415, 515) located only on the raised areas (216) of the uneven surface, where the plurality of second layer areas (215, 415, 515) each include a plastic material or an elastomer.

9. The electronic device (100) of claim 8,
wherein the electronic device (100) is a mobile terminal or a portable computer.

10. The electronic device (100) of claim 8,
wherein the second layer areas (215, 415, 515) include non-thermally conductive areas.

11. The electronic device (100) of claim 10,
wherein the thermally conductive layer (210, 410, 510) includes a metal.

12. The electronic device (100) of claim 8,
wherein the uneven surface includes a wave like contour.

13. The electronic device (100) of claim 8,
wherein the uneven surface includes a hill like contour or a box like contour.

14. The electronic device (100) of claim 8,
wherein the raised areas (216) of the uneven surface are separated from low areas of the uneven surface by approximately 0.2 millimeters to on the order of a few millimeters.

15. A dual function surface (115) of an electronic device (100) comprising:
means for dispersing heat (210), the means for dispersing heat having a thermally conductive uneven surface that includes a plurality of raised areas; and
means for insulating only the raised portions of the uneven surface (216) with a material that is relatively non-thermally conductive, where the material includes a plastic material or an elastomer.

## Patentansprüche

1. Äußere Oberfläche eines elektronischen Geräts (100), welche aufweist:
eine wärmeleitfähige Schicht (210, 410, 510) mit einer unebenen Oberfläche und mindestens einer weiteren Oberfläche, welche thermisch mit einer Wärmequelle (250) gekoppelt ist, wobei die unebene Oberfläche mehrere erste Bereiche (216) aufweist, die höher sind als andere Bereiche der unebenen Oberfläche; und
mehrere Bereiche einer zweiten Schicht (215, 415, 515), die nur auf den ersten Bereichen der unebenen Oberfläche angeordnet sind, wobei die mehreren Bereiche der zweiten Schicht (215, 415, 515) ein Kunststoffmaterial oder ein Elastomer enthalten.

2. Äußere Oberfläche des elektronischen Geräts (100) nach Anspruch 1,
wobei die mehreren Bereiche (215, 415, 515) der zweiten Schicht nicht wärmeleitfähig sind.

3. Äußere Oberfläche des elektronischen Geräts (100) nach Anspruch 1,
wobei die wärmeleitfähige Schicht (210, 410, 510) ein Metall enthält.

4. Äußere Oberfläche des elektronischen Geräts (100) nach Anspruch 1,
wobei die wärmeleitfähige Schicht (210, 410, 510) als Wärmesenke für das Gerät dient.

5. Äußere Oberfläche des elektronischen Geräts (100) nach Anspruch 1,
wobei die Oberfläche der wärmeleitfähigen Schicht ein wellenförmiges Profil aufweist.

6. Äußere Oberfläche des elektronischen Geräts (100) nach Anspruch 1,
wobei die Oberfläche der wärmeleitfähigen Schicht ein hügel- oder kastenförmiges Profil aufweist.

7. Äußere Oberfläche des elektronischen Geräts (100) nach Anspruch 1,
wobei die ersten Bereiche (216) der unebenen Oberfläche in einem Abstand von rund 0,2 bis zu einigen Millimetern von den tiefer liegenden Bereichen der unebenen Oberfläche angeordnet sind.

8. Elektronisches Gerät (100), welches aufweist:
eine Wärmequelle (250); und
einen äußeren Oberflächenteil (115) aus
einer wärmeleitfähigen Schicht (210, 410, 510) mit einer unebenen Oberfläche und mindestens einer weiteren Oberfläche, welche thermisch mit einer Wärmequelle (250) gekoppelt ist, wobei die unebene Oberfläche mehrere erhöhte Bereiche (216) aufweist; und
mehrere Bereiche einer zweiten Schicht (215, 415, 515), die nur auf den erhöhten Bereichen (216) der unebenen Oberfläche angeordnet sind, wobei die mehreren Bereiche der zweiten Schicht (215, 415, 515) jeweils ein Kunststoffmaterial oder ein Elastomer enthalten.

9. Elektronisches Gerät (100) nach Anspruch 8,
wobei das elektronische Gerät (100) ein mobiles Endgerät oder ein tragbarer Computer ist.

10. Elektronisches Gerät (100) nach Anspruch 8,
wobei die mehreren Bereiche der zweiten Schicht (215, 415, 515) nicht wärmeleitfähige Bereiche aufweisen.

11. Elektronisches Gerät (100) nach Anspruch 10,
wobei die wärmeleitfähige Schicht (210, 410, 510) ein Metall enthält.

12. Elektronisches Gerät (100) nach Anspruch 8,
wobei die unebene Oberfläche ein wellenförmiges Profil aufweist.

13. Elektronisches Gerät (100) nach Anspruch 8,
wobei die unebene Oberfläche ein hügel- oder kastenförmiges Profil aufweist.

14. Elektronisches Gerät (100) nach Anspruch 8,
wobei die erhöhten Bereiche (216) der unebenen Oberfläche in einem Abstand von rund 0,2 bis zu einigen Millimetern von den tiefer liegenden Bereichen der unebenen Oberfläche angeordnet sind.

15. Doppelfunktionsoberfläche (115) eines elektronischen Geräts (100), welche aufweist:
Mittel zur Wärmeabführung (210), welches eine wärmeleitfähige unebene Oberfläche mit mehreren erhöhten Bereichen aufweist; and
Mittel zur Isolierung nur der erhöhten Bereiche der unebenen Oberfläche (216) mittels eines Materials, das relativ nicht wärmeleitfähig ist, wo es ein Kunststoffmaterial oder ein Elastomer enthält.

## Revendications

1. Surface externe d'un dispositif électronique (100), comprenant :
une couche conductrice thermiquement (210, 410, 510) ayant une surface irrégulière et au moins une autre surface qui est couplée thermiquement à une source de chaleur (250), la surface irrégulière comprenant une pluralité de premières zones (216) qui sont plus hautes que d'autres zones de la surface irrégulière ; et
une pluralité de zones de deuxième couche (215, 415, 515) situées uniquement sur les premières zones de la surface irrégulière, où la pluralité de zones de deuxième couche (215, 514, 515) comprend une matière plastique ou un élastomère.

2. Surface externe du dispositif électronique (100) selon la revendication 1, dans laquelle la pluralité de zones de deuxième couche (215, 415, 515) est non conductrice thermiquement.

3. Surface externe du dispositif électronique (100) selon la revendication 1, dans laquelle la couche conductrice thermiquement (210, 410, 510) comprend un métal.

4. Surface externe du dispositif électronique (100) selon la revendication 1, dans laquelle la couche conductrice thermiquement (210, 410, 510) sert de dissipateur thermique pour le dispositif.

5. Surface externe du dispositif électronique (100) selon la revendication 1. dans laquelle la surface irrégulière de la couche conductrice thermiquement comprend un contour ondulé.

6. Surface externe du dispositif électronique (100) selon la revendication 1, dans laquelle la surface irrégulière de la couche conductrice thermiquement comprend un contour en collines ou en carrés.

7. Surface externe du dispositif électronique (100) selon la revendication 1, dans laquelle les premières zones (216) de la surface irrégulière sont séparées des zones plus basses de la surface irrégulière d'une distance comprise entre environ 0,2 et quelques millimètres.

8. Dispositif électronique (100) comprenant :
une source de chaleur (250) ; et
une partie de surface externe (115) qui comprend
une couche conductrice thermiquement (210, 410, 510) ayant une surface irrégulière et au moins une autre surface qui est couplée thermiquement à la source de chaleur (250), la surface irrégulière comprenant une pluralité de zones surélevées (216) ; et
une pluralité de zones de deuxième couche (215, 415, 515) situées uniquement sur les zones surélevées (216) de la surface irrégulière, où la pluralité de zones de deuxième couche (215, 415, 515) comprennent chacune une matière plastique ou un élastomère.

9. Dispositif électronique (100) selon la revendication 8, dans lequel le dispositif électronique (100) est un terminal mobile ou un ordinateur portable.

10. Dispositif électronique (100) selon la revendication 8, dans lequel les zones de deuxième couche (215, 415, 515) comprennent des zones non conductrices thermiquement.

11. Dispositif électronique (100) selon la revendication 10, dans lequel la couche conductrice thermiquement (210, 410, 510) comprend un métal.

12. Dispositif électronique (100) selon la revendication 8, dans lequel la surface irrégulière comprend un contour ondulé.

13. Dispositif électronique (100) selon la revendication 8, dans lequel la surface irrégulière comprend un contour en collines ou en carrés.

14. Dispositif électronique (100) selon la revendication 8, dans lequel les zones surélevées (216) de la surface irrégulière sont séparées des zones basses de la surface irrégulière d'une distance comprise entre environ 0,2 et quelques millimètres.

15. Surface à double fonction (115) d'un dispositif électronique (100), comprenant :
un moyen pour disperser la chaleur (210), le moyen pour disperser la chaleur ayant une surface irrégulière conductrice thermiquement qui comprend une pluralité de zones surélevées ; et
un moyen pour isoler uniquement les parties surélevées (216) de la surface irrégulière avec un matériau qui est relativement non conducteur thermiquement, où le matériau comprend une matière plastique ou un élastomère.
